(19) Europäisches Patentamt
European Patent Office
Office européen des brevets

(11) **EP 1 570 573 B1**

(12) **EUROPEAN PATENT SPECIFICATION**

(45) Date of publication and mention
of the grant of the patent:
**25.04.2007 Bulletin 2007/17**

(51) Int Cl.:
*H03G 5/00* *(2006.01)*      *H03G 5/02* *(2006.01)*
*H03G 5/16* *(2006.01)*

(21) Application number: **02808211.3**

(86) International application number:
**PCT/DK2002/000831**

(22) Date of filing: **09.12.2002**

(87) International publication number:
**WO 2004/054099 (24.06.2004 Gazette 2004/26)**

(54) **A FULLY PARAMETRIC EQUALIZER**

VOLLPARAMETRISCHER EQUALIZER

EGALISEUR ENTIEREMENT PARAMETRIQUE

(84) Designated Contracting States:
**AT BE BG CH CY CZ DE DK EE ES FI FR GB GR IE IT LI LU MC NL PT SE SI SK TR**

(43) Date of publication of application:
**07.09.2005 Bulletin 2005/36**

(73) Proprietor: **TC Electronic A/S
8240 Risskov (DK)**

(72) Inventors:
• **CHRISTENSEN, Knud, Bank
DK-8550 Ryomgard (DK)**

• **PEDERSEN, Kim, Rishoj
DK-8250 Ega (DK)**

(74) Representative: **Olesen, Kaj et al
Patentgruppen ApS
Arosgaarden
Aaboulevarden 31
8000 Aarhus C (DK)**

(56) References cited:
**US-A- 4 891 841        US-A- 5 195 141
US-A- 6 163 789**

**Description**

**Field of the invention**

The present invention relates to a parametric equalizer according to claim 1.

**Background of the invention**

Today's equalizers can be divided into graphical and parametrical equalizers. Both types can be implemented in analog or digital signal processing technology. This invention deals with parametric equalizers in analog as well as digital implementations.

Generally a graphical equalizer benefits of the fact that the complete audio spectrum may be divided into several fixed regions with levels controlled in an intuitive way by a user of the equalizer. A significant problem of the graphical equalizer is, however, that the equalizer is quite inflexible and provides very little possibility of accurate control by a user due to the fact that the user is typically restricted to utilization of the pre-defined bands. In practice, such problem would only be solved by the use of even more than thirty bands. Such a device would typically be a very expensive device simply because of sheer duplication of circuitry. Much of the circuitry will be wasted when dealing with several types of equalizing tasks because such types of tasks typically only involve adjustment of two or three bands while others should be left unaffected by the filtering.

An equalizer with adjustable frequency has therefore been provided for the purpose of optimizing the use of signal processing circuitry. Such an equalizer is referred to as a parametric equalizer and has upon introduction in 1972 found wide use especially in professional or semi-professional contexts.

Basically a parametric equalizer features very few control parameters, which, on the other hand may control the curve response with very high resolution.

Typical control parameters are gain, center frequency and Q. Moreover, some parametric equalizers provide three different filter types, a low shelf filter, a bell-shaped filter and a high shelf filter.

A parametric equalizer can produce a very sharp notch, as a graphic equalizer, and maintain the shape over several decades or bands. A parametric equalizer may, contrary to most applicable graphical equalizers produce a magnitude response boost or attenuation at any frequency and may therefore match the average desired sound filtering characteristic somewhat better than graphic equalizers.

An application of a parametric equalizer may for example be suppression of low frequency microphone noise.

A typical parametrical equalizer may comprise a number of filter blocks, which may be cascaded for the purpose of obtaining one desired combined transfer function of the cascaded filters.

Presently, each block is typically one of three types: Low-shelf, parametric (bell-shaped) and high-shelf filter. The low/high shelf filters have three parameters each: Gain G, corner frequency $f_c$ and slope (or Q), and the parametric filters have three similar parameters: Gain G, center frequency $f_c$ and bandwidth BW (or Q).

Examples of such parametric equalizer are disclosed in US 6,163,789 and US 4,891,841.

A problem of the above-mentioned prior art parametric equalizers is that the freedom of operation is somewhat limited and that the full use of the parametric equalizers for certain common desired filter characteristics requires several cascaded filters, thereby increasing the complexity of the complete system and evidently, increasing the costs involved, due to the fact that several units must be applied for the purpose of obtaining the single desired characteristics.

It is the object of the invention to provide an equalizer featuring the above-mentioned advantages of prior art parametric equalizers while ameliorating the above-mentioned disadvantages of the prior art.

**Summary of the invention**

The invention relates to a parametric equalizer comprising
filtering means (FM), user interface means (UIM), audio signal input means and audio signal output means,
said filtering means comprising at least one filter block (FIB)
said user interface means (UIM) comprising means for adjustment of first, second and third independent user parameters: corner frequency (fc), shape (Q) and gain (G),
said parametric equalizer comprising further means for adjusting a symmetry parameter independent to the other user parameters, which may be continuously varied in order to provide a smooth transition between low-shelf, bell-shaped and high-shelf filter characteristic of said at least one filter block (FIB).

According to the invention, it should be noted that the adjustment parameter referred to as a non-trivial parameter and mentioned as "gain" above refers to the sign characteristic of the log magnitude response of the applied filter, i.e. whether the filter defines a boost or an attenuation at the corner frequency.

According to the invention, non-trivial degrees of freedom are the degrees of freedom left, when the overall gain is disregarded or simply handled as a product of the overall gains of the individual filter blocks. In other words, the complete number of degrees of freedom, when dealing with for example a biquadratic filter block, is five, that is one trivial degree of freedom being the overall gain of the filter block and four non-trivial degrees of freedom. This understanding of degrees of freedom is further explained in the detailed description.

Elsewhere, the parameter global gain or overall gain refers to a trivial parameter corresponding to the linear volume setting of the applied filter block or group of filter blocks.

According to the invention, the further adjustment parameter, exemplified by the symmetry parameter, facilitates the possibility of adjustment of the symmetry of the filter magnitude response, both by providing conventional obtainable filter types, such as low-shelf, bell-shaped and high shelf and mixtures or intermediates (with respect to gain symmetry) thereof.

Such intermediate filter would according to one embodiment of the invention comprise a continuos interval of curve shape defined by variation of the symmetry parameters according to the invention. According to a preferred embodiment of the invention, the symmetry may be varied between low frequency gain boost/attenuation anti-symmetry via center frequency symmetry (e.g. bell-shaped) to high frequency boost/attenuation anti-symmetry.

According to a preferred embodiment of the invention, a continuos interval (may of course be established as a high resolution set of discrete filters in the digital world) of filter shapes having magnitude response symmetry varying from one sign of asymmetry to the opposite sign of asymmetry. Preferably, the available continuous number of filter symmetries should comprise the symmetrical instance of the filter design corresponding to the bell-shape.

It should be noted that the gain, Q and fc preferably may be adjusted at every available setting of the Symmetry parameter.

An example of available equalizer filters according to an embodiment of the invention is a filter featuring adjustable asymmetrical over-/undershoot of the filter magnitude response at the selected corner frequency, gain and Q.

According to the invention, the new adjustment parameter may be referred to as the symmetry parameter. The variable symmetry parameter should not be confused with the shape aspects referring to prior art parametric equalizers' variable Q.

According to the invention, the improved control of the equalizer may in fact surprisingly be obtained "free of charge" due to the fact that the improved control may in fact be obtained by the use of conventional filter types, such as biquadratic filter blocks, only now utilizing all four non-trivial degrees of freedom simultaneously.

As it has been appreciated the filtering structure of a parametric equalizer may be regarded as relatively simple at least in the sense that the huge number of processing blocks of for example a graphic equalizer may be avoided.

According to the present invention, this advantage has been maintained while adding significant adjustment features to the user.

According to a particular user-friendly embodiment of the invention, the adjustment parameter may be practically "dimmed" for the purpose of emulating a conventional parametric equalizer. In this way, a user feeling uncomfortable with the adjustment opportunities provided according to the invention may simply convert the equalizer into a conventional and familiar sound-processing device.

In an embodiment of the invention, the user interface means UIM comprises a further symmetry adjustment parameter SYM for establishing a variable symmetry of the magnitude response of said at least one filter block FIB. said user interface means is mapped by means of coefficient adjustment algorithms into filter coefficient settings FCS of the at least one filter block FIB, which when established reflects the adjustment of the user interface means UIM said further adjustment parameter SYM provides a filter coefficient setting FCS comprising a combined adjustment of at least one zero frequency, pole frequency, zero Q and pole Q of the magnitude response at least one filter block.

In an embodiment of the invention said user control means facilitates adjustment of corner frequency, fc, shape, Q, gain and symmetry, SYM.

In an embodiment of the invention said filter coefficient settings FCS comprise digital coefficients.

In an embodiment of the invention said filter coefficient settings FCS comprises analogue values established by means of adjustable analogue filter components of said at least one filtering means.

In an embodiment of the invention said filtering means comprises less than twenty individually adjustable filter blocks FIB, preferably less that ten and most preferably less than six.

It should be noted that the filter blocks of a filtering means, e.g. a parametric equalizer preferably should be individually adjustable, thereby facilitating the cascading and adjusting of some or all the filter blocks of the parametric equalizer.

In an embodiment of the invention at least one of said filtering blocks comprises biquad filters (biquad: biquadratic).

In an embodiment of the invention said parametric equalizer comprises at least one, preferably at least three cascaded biquadratic filters.

In an embodiment of the invention said filtering means is analogously implemented.

In an embodiment of the invention said filtering means is digitally implemented.

In an embodiment of the invention said filtering means comprises gain compensation means adapted for compensation of alteration of the filtering block gain invoked by a changed setting of the further adjustment parameter.

In an embodiment of the invention said filtering means comprises corner frequency compensation means adapted for compensation of alteration of the corner frequency of the filtering block invoked by a changed setting of the further adjustment parameter SYM.

In an embodiment of the invention said further adjustment parameter is adapted for providing an adjustment of both the asymmetry around the corner frequency of at least one filter block FIB and the asymmetry around the half gain of the at least one filter block over at least a part of the frequency range of the filter block.

In an embodiment of the invention said user interface provides at least four different asymmetries of filter setting for at least a part of the frequency range.

In an embodiment of the invention said further adjustment parameter SYM enables the user to gradually transform the filter block FIB between a low-shelf filter characteristic and a high-shelf.

It should be noted that several other desirable asymmetries than the well known low-shelf and high shelf equalizer filters may define the endpoints of the available asymmetries. Even though it is highly preferred that the available symmetries (or rather asymmetries) are defined within an interval of asymmetries in order to facilitate the user to grasp the available modifications, discrete, non-continuous sets of filter characteristics may be offered.

In an embodiment of the invention said further adjustment parameter (SYM) enables the user to gradually transform the filter block (FIB) from a low-shelf into a bell-shape and further into a high-shelf, thus defining at least one more than the three standard filter types.

In an embodiment of the invention the number of said adjustment parameters correspond to the number of degrees of freedom of the at least one filter block.

In an embodiment of the invention the number of said adjustment parameters is four times the number of non-trivial degrees of freedom of at least one biquad filter block.

In an embodiment of the invention the number of non-trivial degrees of freedom of each of a number of cascaded filter blocks is at least four.

A further degree of freedom may be a global gain setting, which may be associated to each filter block or may be shared as a global gain setting shared by all the connectable, typically cascadable, filter blocks.

In an embodiment of the invention the symmetry parameter may be set by means of the user interface to at least four different values, preferably a continuos interval of values in the analog or digital embodiment.

In an embodiment of the invention the adjustment parameters are converted into filter coefficient settings (FCS) triggered by the setting of the adjustment parameters by the user.

According to the invention, the filter coefficient settings may be established "on the fly" triggered by the setting of the adjustment parameters by a user. In this way, memory may be saved.

In an embodiment of the invention the conversion of adjustment parameters into filter coefficient settings is invertible.

In an embodiment of the invention the given filter coefficient settings may be converted into corresponding adjustment parameters.

According to the invention, an initially applied filter may be presented to the user in corresponding parametric equalizer parameter settings. Moreover, the filter may then be tuned by the parametric equalizer according to an embodiment of the invention.

In an embodiment of the invention a method of adjusting the filter coefficients of the filter of a parametric equalizer comprises the step of availing user adjustment of all the degrees of freedom of the transfer function or a block of the transfer function of the filter.

In an embodiment of the invention said availing of user adjustment comprises the steps of adjusting four degrees of freedom per filter block.

In an embodiment of the invention adjustment of the filter coefficients is implemented in a parametric equalizer according to any of claims 1-23.

Moreover, the invention relates to a method of adjusting the filter coefficients of the filter of a parametric equalizer comprising the step of availing user adjustment of all the degrees of freedom of the transfer function or a block of the transfer function of the filter.

**The drawings**

The invention is described in the following with reference to the drawings of nonlimiting examples, of which

fig. 1 illustrates the principle components applied according to an embodiment of the invention,
fig. 2 illustrates the filter characteristics according to an embodiment of the invention,
fig. 3a illustrates a frequency compensated embodiment of the invention,

fig. 3b illustrates a gain compensated embodiment of the invention,

fig. 4 illustrates a block diagram of analog state-variable filter

fig. 5 illustrates a circuit diagram of single analog biquad filter according to an embodiment of the invention,

fig. 6a and 6b illustrate the principle of the invertability obtained according to an embodiment of the invention, and

fig. 7 illustrates a cascade of filter block in an embodiment of the invention, and

**Detailed description**

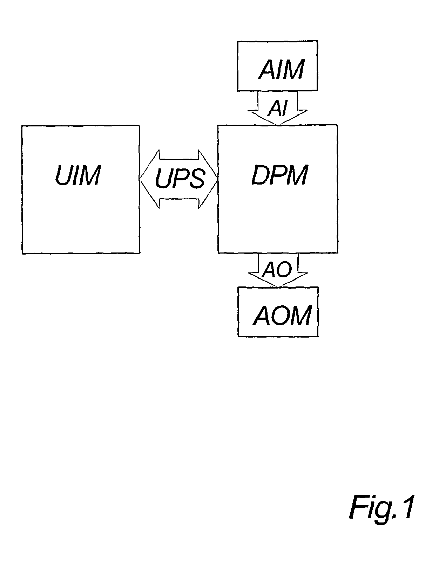

Fig. 1 illustrates the principle components of a parametric equalizer according to an embodiment of the invention.

The main hardware components comprise User Interface Means UIM, Data Processing Means DPM, Audio Input Means AIM and Audio Output Means AOM.

The User Interface Means UIM is adapted for, under the control of a user, establishment of the adjustable parameters controlling the data processing of the Data Processing Means DPM by means of User Parameter Settings UPS controlling the Data Processing Means DPM.

The Data Processing Means DPM comprises suitable data processing hardware and associated circuitry, including memory, clock generators, etc. The Data Processing Means receives Audio Input signals AI provided by the Audio Input Means AIM and outputs Audio Output AO signals to the Audio Output Means AOM.

The Audio Input signals may comprise digital or analog signals. In case of analog signals, the Audio Input Means AIM or the Data Processing Means DPM should preferably comprise the necessary A/D-converters. In case of digital Audio Input AI signals, Audio Input Means AIM or the Data Processing Means DPM should preferably comprise suitable input means.

The User Interface Means UIM comprises suitable adjustments means adapted for manual use. The adjustment means may preferably comprise conventional buttons/knobs/sliders/etc. and associated display means (not shown) or for example be controlled by a computer implemented interface (not shown) comprising the conventional user input means, such as keyboard and/or mouse and monitor.

Turning now to the theoretical background of the invention.

Classic parametric EQ functions comprise adjustment parameters: Low shelf, parametric and high shelf with varying G,fc and Q

As mentioned above these filters are typically implemented as biquadratic blocks (analog case shown here):

$$H(s) = \frac{b_0 s^2 + b_1 s + b_2}{a_0 s^2 + a_1 s + a_2} = g_{overall} \frac{s^2 + \dfrac{\omega_z}{Q_z} s + \omega_z{}^2}{s^2 + \dfrac{\omega_p}{Q_p} s + \omega_p{}^2}$$

where $g_{overall} = \dfrac{b_0}{a_0}, \omega_z = \sqrt{\dfrac{b_2}{b_0}}, Q_z = \dfrac{\sqrt{b_0 b_2}}{b_1}, \omega_p = \sqrt{\dfrac{a_2}{a_0}}, Q_p = \dfrac{\sqrt{a_0 a_2}}{a_1}$

It can be seen that H(s) has 5 degrees of freedom: The overall gain of the individual filter block, which is trivial - equivalent to a volume control -, and 4 non-trivial ones, namely the resonance frequencies and Qs of the numerator and denominator respectively. So each of the standard filter types use only 3 out of 4 degrees of freedom, leaving one degree of freedom un-utilized; shelves let Qp=Qz while parametric bell filter let ωp=ωz. To put it another way the 3 standard filter types (low-shelf, parametric and high-shelf) are but samplings along a 4th parameter axis that has so far been hidden from the user.

**The Symmetry parameter**

The new parameter will be referred to as the *Symmetry* parameter, and according to an embodiment of the invention it is defined so that the three traditional filter types correspond to Symmetry = -1, 0 and 1 respectively. A first implementation of the new parameter goes like this (Algorithm 1):

Given user parameters G in dB, $f_c$ in Hz, Q and *symmetry*:

$$g = 10^{\frac{|G|}{20}}$$

$$\omega = 2\pi f_c$$

$$\omega_z = \omega \cdot g^{\frac{symmetry}{4}}$$

$$\omega_p = \frac{\omega^2}{\omega_z}$$

$$Q_z = Q \cdot g^{|symmetry|-1}$$

$$g_{correction} = \begin{cases} 1 \text{ if } symmetry \leq 0 \\ \left(\dfrac{\omega_p}{\omega_z}\right)^2 \text{ otherwise} \end{cases}$$

$$H(s) = g_{correction} \frac{s^2 + \dfrac{\omega_z}{Q_z}s + \omega_z{}^2}{s^2 + \dfrac{\omega_p}{Q}s + \omega_p{}^2}$$

if $G < 0$ : $H(s) = H(s)^{-1}$

It should be noted that other definitions or adaptation of the symmetry parameter may be applied according to the invention.

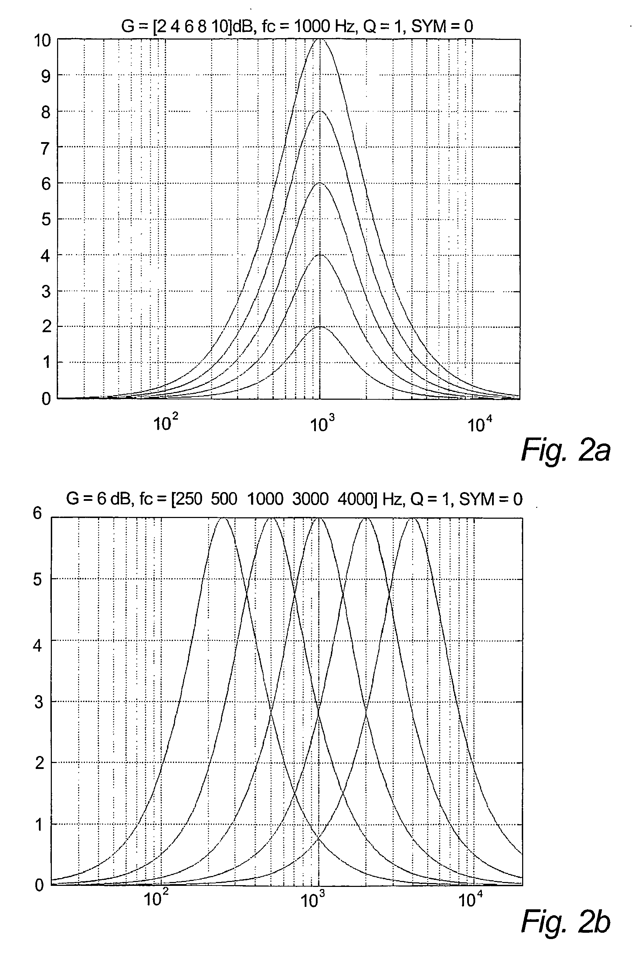

Response examples of a fully parametric EQ, one parameter variation at a time, is illustrated in fig. 2a-2d.

Fig. 2a illustrates a response of the parametric equalizer with variable gain, fixed fc=1000Hz, fixed Q=1 and fixed Symmetry = 0.

Fig. 2b illustrates a response of the parametric equalizer with fixed gain = 6dB, variable corner frequency fc, fixed Q=1 and fixed Symmetry = 0.

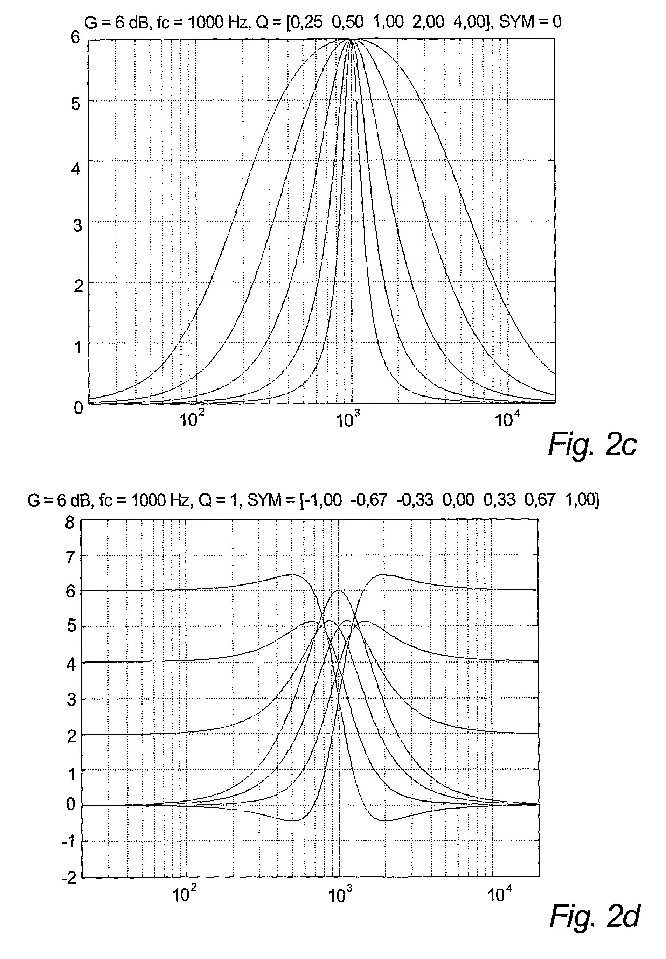

Fig. 2c illustrates a response of the parametric equalizer with fixed gain = 6dB, fixed corner frequency fc=1000Hz, variable Q and fixed Symmetry = 0.

Fig. 2d illustrates a response of the parametric equalizer with fixed gain = 6dB, fixed corner frequency fc=1000Hz, fixed Q=1 and variable Symmetry.

It should be noted that the illustrated obtainable curve forms incorporate both the traditional available settings and the complete range of the fourth parameter, Symmetry.

This is pinpointed in fig. 2d, where the obtained filter characteristic itself is advantageous and where the filter may be obtained by advantageous and simple control.

In the embodiment of the invention illustrated in fig. 2d, the SYM (SYM: *Symmetry*) parameter exhibits two to a certain degree undesired properties:

1. The peak of the magnitude response shifts in frequency causing an undesirable change of tonal "center of gravity" when operating the Symmetry parameter. This is due to the fact that in algorithm 1, the corner frequency of a shelf filter is defined as mid-slope frequency, while that of a bell shaped is the frequency where the magnitudes deviate the most from 0 dB.

2. At intermediate Symmetry settings, the magnitude may not reach the prescribed gain (G) setting at any frequency. This may not be very intuitive to a user.

Many users will ignore the above-mentioned properties. According to a further embodiment of the invention, these properties will compensated.

The first feature may be reduced by mapping the chosen $f_c$ into the pole frequency of all filter symmetries, and thus redefining the meaning of the $f_c$ parameter for the classic shelf type filters (Algorithm 2):

Given user parameters $G$ in dB, $f_c$ in Hz, $Q$ and *symmetry*:

$$g = 10^{\frac{|G|}{20}}$$

$$\omega = 2\pi f_c$$

$$\omega_z = \omega \cdot g^{-\frac{symmetry}{2}}$$

$$Q_z = Q \cdot g^{|symmetry|-1}$$

$$g_{correction} = \begin{cases} 1 \text{ if } symmetry \leq 0 \\ \left(\dfrac{\omega}{\omega_z}\right)^2 \text{ otherwise} \end{cases}$$

$$H(s) = g_{correction} \frac{s^2 + \dfrac{\omega_z}{Q_z}s + \omega_z^{\,2}}{s^2 + \dfrac{\omega}{Q}s + \omega^2}$$

if $G < 0$ : $H(s)=H(s)^{-1}$

The above described mapping may be regarded as a frequency compensation of Symmetry parameter invoked equalizer curve modification, when compared to conventional understanding of the corner frequency.

Evidently, several other more or less intuitive compensations may be applied.

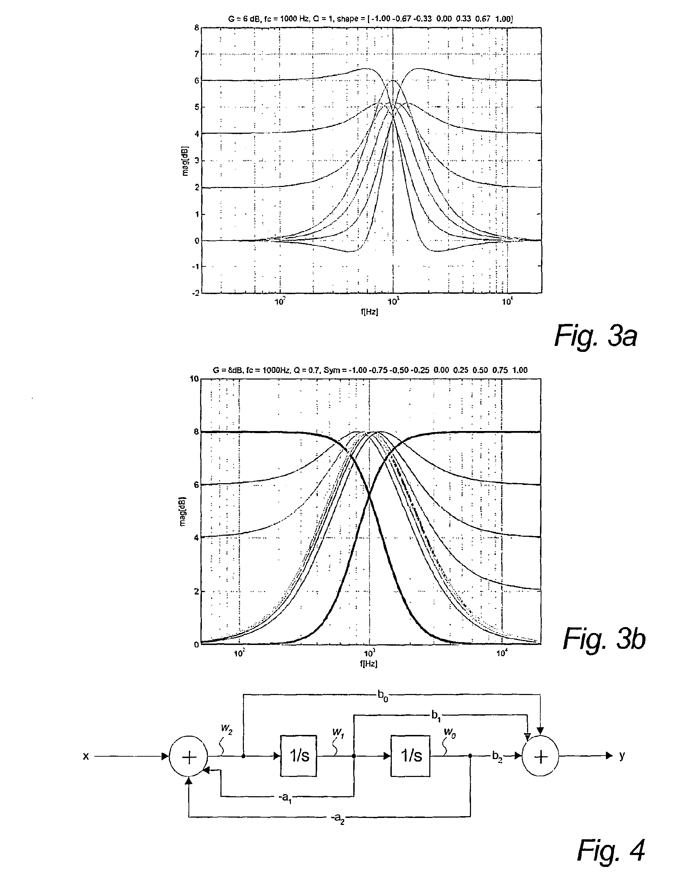

Figure 3a illustrate the functioning of Symmetry parameter with constant pole frequency as described above.

The second property can be reduced by modifying the Gain parameter, the first order numerator coefficient of H(s) when G>0 or the first order denominator coefficient when G<0 according to some empirical function. Note however, the meaningful relationship between the asymptotic gain and the Symmetry setting in figure 2 and 3:

$$G_{asymptotic} = |symmetry| \cdot G, \text{ both gains in dB}$$

The gain compensation may be obtained according to several different approaches if desired. One approach may be that of fixing the asymptotic values (by gain compensation of the resulting filter) of the gain at low frequencies or at high frequencies.

Another approach would be fixing the gain or attenuation peak at a certain value.

Fig. 3b illustrates a gain compensation applied for the purpose of equaling the maximum gain obtained at or near the corner frequency. It should be stressed, as stated above, that several other manual or automatic compensation techniques may be applied, both with respect to gain and the corner frequency in order to fit the users expectations with respect to the development of the gain and the frequency when modifying the user adjustable parameters. One of several examples of such may for example be a combination of the above described frequency and gain compensation.

Such techniques may also imply empirically established compensations.

**Invertibility**

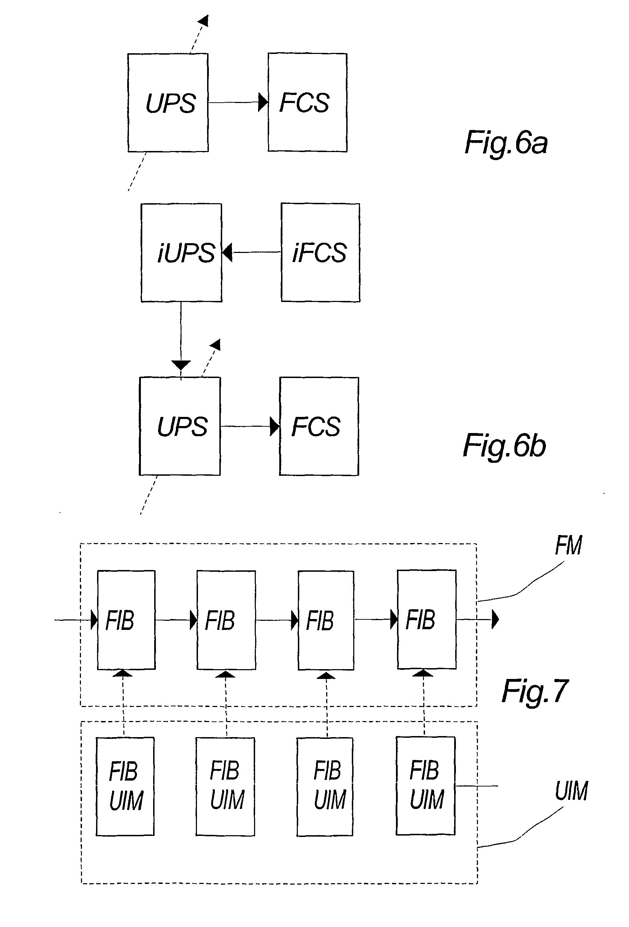

Fig. 6a and fig. 6b illustrate the possibilities and advantages of the herein referred to invertibility of the parametric equalizer according to an embodiment of the invention. In fig. 6a, User Parameter Settings UPS may be adjusted by a user. Such settings may, according to an embodiment of the invention comprise gain, corner frequency, Q and Symmetry.

The parameters control suitable hardware means (not shown)

The adjustable settings may then, in a suitable way be transformed into filter coefficient setting FCS, e.g. coefficient of a biquad filter, analog or digital.

In fig. 6b, however, an initial set of Filter Coefficient Settings iFCS is applied as initial coefficient settings of applied filter. These settings may e.g. be retrieved from a bank of settings available to the user. Such initial settings may for example be established on the basis of complex filter design algorithms or they may represent for example settings of preferred filters, earlier tested and approved by the user.

The settings may then, due to the invertibility of the applied parameters settings and the corresponding filter settings, be converted into corresponding initial User Parameter Settings, iUPS. These settings may then be fine-tuned or modified by the user, by means of his preferred tuning means, the parametric equalizer according to the invention, as illustrated in fig. 6a.

This invertibilty-feature is in particular an advantage in relation to audio signal processing due to the fact that the input signals, such as voice or instruments, typically varies quite significantly, thereby requiring individual filter settings, not only with respect to variation of sound, but sometimes also with respect for the rendering "room". Due to the fact that such tuning has to be performed in the parameter domain, it is a significant advantage according to an embodiment of the invention, that filters established on the basis of coefficient settings (e.g. by a filter design program in the coefficient domain) may be presented to the user in the parameter domain.

According to an embodiment of the invention, the user may now retrieve an initial setting completely described by the available adjustable User Parameter Settings UPS and he may modify the parameters by his preferred adjustment means, the parameter modifications available by means of the parametric equalizer.

The principle of releasing the last degree of freedom for user adjustment has provided a parametric equalizer, featuring the same benefits obtained by conventional parametric equalizer with respect to easy and flexible tuning together with the possibility of modifying the obtaining equalizer characteristics into several other curve forms than offered until now.

In principle, the adjustment may be obtained by other types of adjustment parameters than the typical parameters corner frequency, gain and Q.

In practice, an arbitrary order of the applied filter in the parametric equalizer may be converted into a cascade of biquad filters.

As long as the equalizer algorithm is not complicated further than for example algorithm 1 or 2, the parametric equalizer according to an embodiment of the invention is invertible, meaning that there exists a unique translation from filter coefficients back to parameters.

Invertibility may also be expressed as the ability to map a continuum of the coefficient space "back" into parametric equalizer parameter settings.

An inverse algorithm is a little more complicated (Algorithm 3):

$$\text{Given } H(s) = \frac{b_0 s^2 + b_1 s + b_2}{a_0 s^2 + a_1 s + a_2}$$

$$\omega_z = \sqrt{\frac{b_2}{b_0}}; \ \omega = \sqrt{\frac{a_2}{a_0}}$$

$$Q_z = \omega_z \frac{b_0}{b_1}; \ Q = \omega \frac{a_0}{a_1}$$

$$symmetry = 0$$

If $\omega \neq \omega_z$: $symmetry = \dfrac{2}{2 - \dfrac{\log(Q_z) - \log(Q)}{\log(\omega) - \log(\omega_z)}}$ Endif *)

If $symmetry < 0$ or $|symmetry| > 1$: $symmetry = \dfrac{2}{-2 - \dfrac{\log(Q_z) - \log(Q)}{\log(\omega) - \log(\omega_z)}}$ Endif *)

If $|symmetry| > 0.5$: $g = (\dfrac{\omega_z}{\omega})^{\frac{2}{symmetry}}$ Else $g = (\dfrac{Q_z}{Q})^{\frac{1}{|symmetry| - 1}}$ Endif *)

Handle special limiting cases:
If $||symmetry|-1| < 10^{-3}$ :

$$M_{DC} = 20 log_{10}(\frac{b_2}{a_2}); \ M_{\infty} = 20 log_{10}(\frac{b_0}{a_0})$$

If $(|M_{DC}| < 10^{-3}$ & $symmetry < 0)$ or $(|M_{\infty}| < 10^{-3}$ & $symmetry > 0)$ :

$$symmetry = -symmetry; \ g = \frac{1}{g}$$

Endif
Endif

If $g < 1$: $Q = Q_z$; $f_c = \dfrac{\omega_z}{2\pi}$ Else: $f_c = \dfrac{\omega}{2\pi}$ Endif

$G = 20 log_{10}(g)$
*): Here log is a logarithm with any base
The invertibility of the fully parametric EQ opens up another line of application besides the normal EQ.
A filter block applied according to the invention provided may, if it is strictly minimum-phase and has equal number of poles and zeros, no matter if it is the result of human adjustment or computer optimization be transformed back into a parameter set that makes sense to human beings, and thus enables the human user to gain understanding of- and add further fine-tuning to - the result of such a computerized filter design. This can be quite useful in advanced development systems e.g. for tuning active loudspeakers.
A strictly minimum phase filter has no zeros in the right-hand half-plane including the jω axis in case of an analogue filter or no zeros on or outside the unit circle in case of a filter.
It may be appreciated that, for the purpose solely of obtaining the possibility of converting a given filter setting into at least one set of corresponding parameters, setting the number of adjustable parameters should at least be the number of the non-trivial degrees of freedom. In other words, NDOFpar ≥ NDOFcoef, where NDOFpar is the number of adjustable equalizer parameters and NDOFcoef is the number of non-trivial degrees of freedom in the filter transfer function. Most preferably NDOFpar =NDOFcoef.

**Analog implementation**

Fig. 4 illustrates the block diagram of an analog implementation of an embodiment of the invention.
A section of the full-parametric EQ can be implemented as an analog state-variable filter, whose block diagram is shown in fig. 4. The "1/s" blocks are integrators, the "w" nodes are internal signals and the "a" and "b" connections represent connections with gains.
The transfer function of this circuit can be found as follows:

$$w_2 = x - \frac{a_1}{s} w_2 - \frac{a_2}{s^2} w_2 \Leftrightarrow w_2 \left[ 1 + \frac{a_1}{s} + \frac{a_2}{s^2} \right] = x \Leftrightarrow w_2 = \frac{1}{1 + \frac{a_1}{s} + \frac{a_2}{s^2}} x = \frac{s^2}{s^2 + a_1 s + a_2} x$$

$$w_1 = \frac{1}{s} w_2 = \frac{s}{s^2 + a_1 s + a_2} x$$

$$w_0 = \frac{1}{s} w_1 = \frac{1}{s^2 + a_1 s + a_2} x$$

$$y = b_2 w_0 + b_1 w_1 + b_0 w_2 = \frac{b_0 s^2 + b_1 s + b_2}{s^2 + a_1 s + a_2} x = b_0 \frac{s^2 + \frac{b_1}{b_0} s + \frac{b_2}{b_0}}{s^2 + a_1 s + a_2} x$$

$$H(s) = \frac{y}{x} = b_0 \frac{s^2 + \frac{b_1}{b_0} s + \frac{b_2}{b_0}}{s^2 + a_1 s + a_2}$$

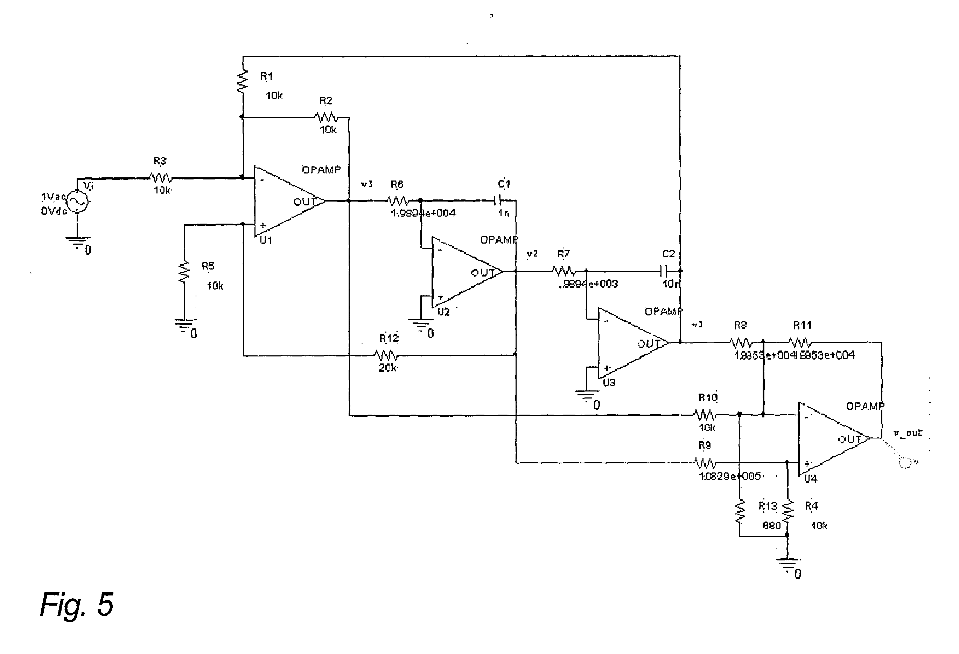

This can be built from real-world electronics using four op-amps in the classical state-variable configuration as illustrated in fig. 5.
Fig. 5 illustrates the electronic schematics of an analog implementation of the block diagram of fig. 4. The voltages $v_1, v_2, v_3$ and $v_{out}$ can be calculated from $v_i$ as follows:

$$v_3 = v_2 \frac{R_5}{R_5 + R_{12}} \frac{R_2 + R_1 \| R_3}{R_1 \| R_3} - v_i \frac{R_2}{R_3} - v_1 \frac{R_2}{R_1}; \quad v_2 = -v_3 \frac{1}{sR_6 C_1}; \quad v_1 = -v_2 \frac{1}{sR_7 C_2} = v_3 \frac{1}{s^2 R_6 C_1 R_7 C_2}$$

$$\Leftrightarrow v_3 = -v_3 \frac{1}{sR_6 C_1} \frac{R_5}{R_5 + R_{12}} \frac{R_2 + \frac{R_1 R_3}{R_1 + R_3}}{\frac{R_1 R_3}{R_1 + R_3}} - v_i \frac{R_2}{R_3} - v_3 \frac{1}{s^2 R_6 C_1 R_7 C_2} \frac{R_2}{R_1}; \quad do$$

$$\Leftrightarrow v_3 \left( \frac{1}{sR_6 C_1} \frac{R_5}{R_5 + R_{12}} \frac{R_1 R_2 + R_2 R_3 + R_1 R_3}{R_1 R_3} + \frac{1}{s^2 R_6 C_1 R_7 C_2} \frac{R_2}{R_1} + 1 \right) = -v_i \frac{R_2}{R_3}; \quad do$$

where the "||" operator is defined as $x \parallel y = \left( \dfrac{x \cdot y}{x + y} \right)$ or equivalently $x_1 \parallel x_2 \parallel \ldots \parallel x_n = \left( \displaystyle\sum_{i=1}^{n} x_i^{-1} \right)^{-1}$

Common denominator: $s^2 R_6 C_1 (R_5 + R_{12}) R_1 R_3 R_7 C_2$

$$\Leftrightarrow v_3 \left( \frac{sR_7 C_2 R_5 \left( R_1 R_2 + R_2 R_3 + R_1 R_3 \right) + \left( R_5 + R_{12} \right) R_3 R_2 + s^2 R_6 C_1 \left( R_5 + R_{12} \right) R_1 R_3 R_7 C_2}{s^2 R_6 C_1 \left( R_5 + R_{12} \right) R_1 R_3 R_7 C_2} \right) = -v_i \frac{R_2}{R_3} ; \ do$$

$$\Leftrightarrow \frac{v_3}{v_i} = -\frac{R_2}{R_3} \frac{s^2 R_6 C_1 \left( R_5 + R_{12} \right) R_1 R_3 R_7 C_2}{s^2 R_6 C_1 \left( R_5 + R_{12} \right) R_1 R_3 R_7 C_2 + sR_7 C_2 R_5 \left( R_1 R_2 + R_2 R_3 + R_1 R_3 \right) + \left( R_5 + R_{12} \right) R_3 R_2}$$

$$= -\frac{R_2}{R_3} \frac{s^2}{s^2 + s \dfrac{R_7 C_2 R_5 \left( R_1 R_2 + R_2 R_3 + R_1 R_3 \right)}{R_6 C_1 \left( R_5 + R_{12} \right) R_1 R_3 R_7 C_2} + \dfrac{\left( R_5 + R_{12} \right) R_3 R_2}{R_6 C_1 \left( R_5 + R_{12} \right) R_1 R_3 R_7 C_2}}$$

$$= -\frac{R_2}{R_3} \frac{s^2}{s^2 + s \dfrac{R_5 \left( R_1 R_2 + R_2 R_3 + R_1 R_3 \right)}{R_6 C_1 \left( R_5 + R_{12} \right) R_1 R_3} + \dfrac{R_2}{R_6 C_1 R_1 R_7 C_2}} ;$$

$$v_2 = -v_3 \frac{1}{sR_6 C_1} ; \quad v_i = v_3 \frac{1}{s^2 R_6 C_1 R_7 C_2}$$

This leaves us with far more than the necessary 2 degrees of freedom for composing the denominator polynomial:

$$Den(s) = s^2 + s \frac{R_5 \left( R_1 R_2 + R_2 R_3 + R_1 R_3 \right)}{R_6 C_1 \left( R_5 + R_{12} \right) R_1 R_3} + \frac{R_2}{R_6 C_1 R_1 R_7 C_2} = s^2 + \frac{\omega}{Q} s + \omega^2$$

To simplify things we choose $R_1 = R_2 = R_3 = R_5 \equiv R_{1235}$ and $R_{12} \equiv 2R_{1235}$, so

$$Den(s) = s^2 + s \frac{1}{R_6 C_1} + \frac{1}{R_6 C_1 R_7 C_2}$$

and (continuing calculations)

$$\frac{v_3}{v_i} = -\frac{s^2}{s^2 + s\frac{1}{R_6 C_1} + \frac{1}{R_6 C_1 R_7 C_2}} \; ; \; v_2 = -v_3 \frac{1}{sR_6 C_1} \; ; \; v_1 = v_3 \frac{1}{s^2 R_6 C_1 R_7 C_2}$$

$$\Rightarrow \frac{v_2}{v_i} = \frac{s\frac{1}{R_6 C_1}}{s^2 + s\frac{1}{R_6 C_1} + \frac{1}{R_6 C_1 R_7 C_2}} \; ; \; \frac{v_1}{v_i} = -\frac{\frac{1}{R_6 C_1 R_7 C_2}}{s^2 + s\frac{1}{R_6 C_1} + \frac{1}{R_6 C_1 R_7 C_2}}$$

So the 3 signals v1, v2 and v3 are LP, BP and HP filtered versions of the input with pass band gains of -1,1 and -1 respectively. Note that these transfer functions are independent of the chosen $R_{1235}$, which may be chosen arbitrarily to $R_{1235}$ = 10 kΩ, for instance. The components determining the pole positions can be chosen as follows:

$$Z_{typ} = 10k\Omega$$

$$C_1 = round\_to\_nearest\left(\frac{Q}{\omega Z_{typ}}\right)$$

$$\frac{\omega}{Q} = \frac{1}{R_6 C_1} \Leftrightarrow R_6 = \frac{Q}{\omega C_1}$$

$$C_2 = round\_to\_nearest\left(\frac{1}{Z_{typ}^2 C_1 \omega^2}\right)$$

$$\omega^2 = \frac{1}{R_6 C_1 R_7 C_2} \Leftrightarrow R_7 = \frac{1}{\omega^2 R_6 C_1 C_2}$$

Now combining the 3 signals in the summing amplifier (U4 in fig. 5), creates the numerator of the EQ's transfer function:

$$v_{out} = -\frac{R_{11}}{R_{10}} v_3 + \frac{R_4}{R_4 + R_9} \frac{R_{11} + R_8 \| R_{10} \| R_{13}}{R_8 \| R_{10} \| R_{13}} v_2 - \frac{R_{11}}{R_8} v_1$$

$$= \frac{\dfrac{R_{11}}{R_{10}} s^2 + \dfrac{R_4}{R_4 + R_9} \dfrac{R_{11} + R_8 \| R_{10} \| R_{13}}{R_8 \| R_{10} \| R_{13}} \dfrac{1}{R_6 C_1} s + \dfrac{R_{11}}{R_8} \dfrac{1}{R_6 C_1 R_7 C_2}}{s^2 + s \dfrac{1}{R_6 C_1} + \dfrac{1}{R_6 C_1 R_7 C_2}} v_i$$

$$= \frac{\dfrac{R_{11}}{R_{10}} s^2 + \dfrac{R_4}{R_4 + R_9} \dfrac{R_8 R_{10} R_{11} + R_8 R_{11} R_{13} + R_{10} R_{11} R_{13} + R_8 R_{10} R_{13}}{R_8 R_{10} R_{13}} \dfrac{1}{R_6 C_1} s + \dfrac{R_{11}}{R_8} \dfrac{1}{R_6 C_1 R_7 C_2}}{s^2 + s \dfrac{1}{R_6 C_1} + \dfrac{1}{R_6 C_1 R_7 C_2}} v_i$$

$$= \frac{R_{11}}{R_{10}} \frac{s^2 + \dfrac{R_4}{R_4 + R_9} \dfrac{R_8 R_{10} R_{11} + R_8 R_{11} R_{13} + R_{10} R_{11} R_{13} + R_8 R_{10} R_{13}}{R_8 R_{11} R_{13}} \dfrac{1}{R_6 C_1} s + \dfrac{R_{10}}{R_8} \dfrac{1}{R_6 C_1 R_7 C_2}}{s^2 + s \dfrac{1}{R_6 C_1} + \dfrac{1}{R_6 C_1 R_7 C_2}} v_i$$

Again, there are too many degrees of freedoms to obtain the desired overall EQ transfer function:

$$EQ(s) = \frac{v_{out}}{v_i}$$

$$= \frac{R_{11}}{R_{10}} \frac{s^2 + \dfrac{R_4}{R_4 + R_9} \dfrac{R_8 R_{10} R_{11} + R_8 R_{11} R_{13} + R_{10} R_{11} R_{13} + R_8 R_{10} R_{13}}{R_8 R_{11} R_{13}} \dfrac{1}{R_6 C_1} s + \dfrac{R_{10}}{R_8} \dfrac{1}{R_6 C_1 R_7 C_2}}{s^2 + s \dfrac{1}{R_6 C_1} + \dfrac{1}{R_6 C_1 R_7 C_2}}$$

$$= g_{correction} \frac{s^2 + \dfrac{\omega_z}{Q_z} s + \omega_z^2}{s^2 + \dfrac{\omega}{Q} s + \omega^2}$$

Selecting $R_{10}$ and $R_4$ to suitable values (e.g. 10 kΩ) the remaining component values are given by:

$$\frac{R_{11}}{R_{10}} = g_{correction} \Leftrightarrow R_{11} = g_{correction} R_{10}$$

$$\frac{R_{10}}{R_8} = \frac{\omega_z^2}{\omega^2} \Leftrightarrow R_8 = R_{10} \frac{\omega^2}{\omega_z^2}$$

$$\frac{R_4}{R_4 + R_9} \frac{R_8 R_{10} R_{11} + R_8 R_{11} R_{13} + R_{10} R_{11} R_{13} + R_8 R_{10} R_{13}}{R_8 R_{11} R_{13}} = \frac{\dfrac{\omega_z}{Q_z}}{\dfrac{\omega}{Q}} = \frac{\omega_z Q}{\omega Q_z}$$

$$\Leftrightarrow R_4 \frac{R_8 R_{10} R_{11} + R_8 R_{11} R_{13} + R_{10} R_{11} R_{13} + R_8 R_{10} R_{13}}{R_8 R_{11} R_{13}} = \frac{\omega_z Q}{\omega Q_z}\left(R_4 + R_9\right)$$

$$\Leftrightarrow \frac{\omega_z Q}{\omega Q_z} R_9 = R_4 \left( \frac{R_8 R_{10} R_{11} + R_8 R_{11} R_{13} + R_{10} R_{11} R_{13} + R_8 R_{10} R_{13}}{R_8 R_{11} R_{13}} - \frac{\omega_z Q}{\omega Q_z} \right)$$

$$\Leftrightarrow R_9 = \frac{\dfrac{R_8 R_{10} R_{11} + R_8 R_{11} R_{13} + R_{10} R_{11} R_{13} + R_8 R_{10} R_{13}}{R_8 R_{11} R_{13}} - \dfrac{\omega_z Q}{\omega Q_z}}{\dfrac{\omega_z Q}{\omega Q_z}} R_4$$

$$= \left( \frac{R_8 R_{10} R_{11} + R_8 R_{11} R_{13} + R_{10} R_{11} R_{13} + R_8 R_{10} R_{13}}{R_8 R_{11} R_{13}} \frac{\omega Q_z}{\omega_z Q} - 1 \right) R_4$$

Note that $R_9$ may become negative. To prevent this from happening within a selected parameter range, we can select a suitably low $R_{13}$ to boost the amplification of the summing amplifier's non-inverting input.

## Digital implementations

When attempting to make a digital signal processing system work like an analog prototype, like our equalizer, a number of compromises must be made. The discrete-time nature of the digital system causes the frequency representation of digital signals to be limited to the range from 0 Hz to the Nyquist frequency $f_{Nq}$ (half the samplingrate $f_s$), while in the continuous analog world, the frequency axis continues towards infinity. The mapping of the infinite analog frequency axis onto the finite digital frequency axis can be done in several, imperfect ways.

### Direct implementation by bilinear transform

A computationally convenient method with some virtue is the Bilinear Transform, which maps the entire analog frequency axis (actually the imaginary axis in the complex s-plane) onto the digital frequency axis (actually the unit circle in the complex z-plane), and ensures that stable analog systems are mapped into stable digital systems. The mapping of an infinitely long axis onto a circle of finite circumference is bound to involve some sort of compression or warping. To ensure that the corner frequency of the digital equalizer ends up at the desired value in spite of the warping, it must be pre-warped before doing the design. Unfortunately this only ensures that this one frequency is mapped correctly, the others are still warped, causing a distorted frequency response at high frequencies near $f_{Nq}$.

The design of a digital version of the parametric equalizer by bilinear transform requires these steps:

1. Prewarp the desired center frequency $f_c$ of the resulting digital filter into an analog design center frequency

$$f_{c,a} = \frac{f_s}{\pi} \tan\left( \frac{\pi}{f_s} f_c \right)$$

2. Design the analog EQ (EQ: Equalizer) by the earlier described Algorithm 2

3. Apply the bilinear transform by substituting the complex frequency variable s in the analog EQ transfer function

by $s = 2f_s \dfrac{1-z^{-1}}{1+z^{-1}}$

4. Renormalize the digital transfer function t to $H(z) = \dfrac{b_1 + b_2 z^{-1} + b_3 z^{-2}}{1 + a_2 z^{-1} + a_3 z^{-2}}$

Because the bilinear transform is invertible, the invertibility property holds for the digital implementations of the fully parametric equalizer, when the direct implementation by bilinear transform is used.

**Implementation by digital design**

Do we really need to "design" our digital EQ by some transformation of the analog filter coefficients? Why not use mathematics to approximate the magnitude response of the digital filter directly to that of the analog prototype, or to any other target response for that matter? In simplified terms, this method goes as follows:

1. Convert user parameter settings (G,fc,Q,Symmetry) into analog coefficients described above.
2. Calculate samples of the analog filter's magnitude response at an appropriate selection of frequencies
3. Design a bi-quadratic digital filter to fit the sampled magnitude/frequency points, using general purpose IIR filter design techniques

The digital design method is much preferable if it can be implemented with sufficient computational efficiency on a product platform. Note that it even supports $f_c$ settings above the Nyquist frequency.

Since the Implementation by a digital design method in general involves approximate IIR filter design techniques such as least-squares approximation, it may not be invertible, but an inverse approximation may be found, yielding only approximate invertibility. Therefore the Direct Implementation by Bilinear Transform may be the preferable method in cases where exact invertibility is important.

Fig. 7 illustrates a principle design of the filtering means FM of an embodiment of the invention.

The illustrated filtering means FM of a parametric equalizer according to an embodiment of the invention comprises a number of filter blocks FIB, here four.

The filter blocks FIB may be cascaded to form one resulting filtering means.

The individual filtering blocks FIB may according to a preferred embodiment of the invention preferably each comprise a biquad filter

Each of the illustrated filtering blocks FIB is moreover individually controlled by a filtering block user interface means FIBUIM. In other words, each of the illustrated filter blocks may be controlled by a user in the parameter domain by means of for example the parameters corner frequency (fc), Shape (Q), gain (G) and symmetry (SYM). Again, in this context Gain is expressed conventionally as boost/attenuation characteristic while the overall gain is referred to as the general volume setting of the individual filter block. The overall gain may typically be shared between all cascaded filters as a common volume setting.

On other words, a control parameter other than the above described four may be the global or overall gain, which may be applied to the individual filters or more likely as one shared trivial volume control.

It should of course be noted that the number of filtering blocks of a device according to the invention in principle may vary from one to for example hundreds.

Typically, a relatively low number of filter blocks FIB which may be cascaded is preferred, e.g. 3 to 8.

The resulting and/or the individual filter curve settings may be illustrated on one or more displays.

It should moreover be noted that the applied filter blocks comprise biquad filters. However, other filter types of smaller or larger order may be applied if suitable.

**Claims**

1. Parametric equalizer comprising
filtering means (FM), user interface means (UIM), audio signal input means and audio signal output means,
said filtering means comprising at least one filter block (FIB)
said user interface means (UIM) comprising means for adjustment of first, second and third independent user parameters: corner frequency (fc), shape (Q) and gain (G),

said parametric equalizer comprising further means for adjusting a symmetry parameter independent to the other user parameters, which may be continuously varied in order to provide a smooth transition between low-shelf, bell-shaped and high-shelf filter characteristic of said at least one filter block (FIB).

2. Parametric equalizer according to claim 1, wherein
said user interface means (UIM) comprises a further symmetry adjustment parameter (SYM) for establishing a variable symmetry of the magnitude response of said at least one filter block (FIB),
said user interface means is mapped by means of coefficient adjustment algorithms into filter coefficient settings (FCS) of the at least one filter block (FIB), which when established reflects the adjustment of the user interface means (UIM)
said further adjustment parameter (SYM) provides a filter coefficient setting (FCS) comprising a combined adjustment of at least one zero frequency, pole frequency, zero Q and pole Q of the magnitude response of said at least one filter block.

3. Parametric equalizer according to claim 1 or 2, wherein
said user control means facilitates adjustment of corner frequency (fc), Shape (Q), gain and symmetry.

4. Parametric equalizer according to any of claims 1-3, wherein
said filter coefficient settings (FCS) comprise digital coefficients.

5. Parametric equalizer according to any of the claims 1-4, wherein
said filter coefficient settings (FCS) comprise analogue values established by means of adjustable or selectable filter components of said at least one filtering means.

6. Parametric equalizer according to any of the claims 1-5, wherein
said filtering means comprises less than twenty individually adjustable filter blocks (FIB), preferably less that ten and most preferably less than six.

7. Parametric equalizer according to any of the claims 1-6, wherein
at least one of said filtering blocks comprise a biquatic filter.

8. Parametric equalizer according to any of the claims 1-7, wherein
said parametric equalizer comprises at least one, preferably at least three cascaded biquadratic filters blocks (FIB).

9. Parametric equalizer according to any of the claims 1-8, wherein
said filtering means is analogously implemented.

10. Parametric equalizer according to any of the claims 1-9, wherein
said filtering means is digitally implemented.

11. Parametric equalizer according to any of the claims 1-10, wherein
said filtering means comprises gain compensation means adapted for compensation of alteration of the filtering block gain invoked by a changed setting of the further adjustment parameter.

12. Parametric equalizer according to any of the claims 1-11, wherein
said filtering means comprises corner frequency compensation means adapted for compensation of alteration of the corner frequency of the filtering block invoked by a changed setting of the further adjustment parameter.

13. Parametric equalizer according to any of the claims 1-12, wherein
said user interface provides at least four different asymmetries of filter setting at least in part of the frequency range.

14. Parametric equalizer according to any of the claims 1-13, wherein
said further adjustment parameter (SYM) enables the user to gradually transform the filter block (FIB) between a low-shelf and a high-shelf filter characteristic.

15. Parametric equalizer according to any of the claims 1-13, wherein
said further adjustment parameter (SYM) enables the user to gradually transform the filter block (FIB) from a low-shelf into a bell-shape and further into a high-shelf, thus defining at least one more than said three standard filter types.

**16.** Parametric equalizer according to any of the claims 1-15, wherein the number of said adjustment parameters corresponds the number of non-trivial degrees of freedom of the at least one filter block (FIB).

**17.** Parametric equalizer according to any of the claims 1-16, wherein the number of said adjustment parameters is at least the number of non-trivial degrees of freedom of the at least biquad filter block (FIB) times the number of filter blocks (FIB) of said filtering means.

**18.** Parametric equalizer according to any of the claims 1-17, wherein the number of non-trivial degrees of freedom of each of a number of cascaded filter block is at least four.

**19.** Parametric equalizer according to any of the claims 1-18, wherein the symmetry parameter may be set by means of the user interface to at least four different values, preferably a continuos interval of values in the digital or analog embodiment.

**20.** Parametric equalizer according to any of the claims 1-19, wherein the adjustment parameters are converted into filter coefficient settings (FCS) triggered by the setting of the adjustment parameters by the user.

**21.** Parametric equalizer according to any of the claims 1-20, wherein the conversion of adjustment parameters into filter coefficient settings is invertible.

**22.** Parametric equalizer according to any of the claims 1-21, wherein NDOFpar $\geq$ NDOFcoef, where NDOFpar is the number of adjustable equalizer parameters and NDOFcoef is the number of non-trivial degrees of freedom (fc, G, Q, Sym).

**23.** Parametric equalizer according to any of the claims 1-22, wherein given filter coefficient settings may be converted into corresponding adjustment parameters.

**24.** Parametric equalizer according to any of the claims 1-23, wherein the corner frequency of a shelf filter designates a mid-slope frequency while that of a bell-shaped filter designates a center frequency.

**Patentansprüche**

**1.** Parametrischer Equalizer umfassend
ein Filtermittel (FM), ein Benutzerschnittstellenmittel (UIM), ein Audiosignaleingabemittel und ein Audiosignalausgabemittel,
wobei das Filtermittel wenigstens einen Filterblock (FIB) umfasst,
das Benutzerschnittstellenmittel (UIM) ein Mittel zum Einstellen eines ersten, zweiten und dritten unabhängigen Benutzerparameters umfasst: Eckfrequenz (fc), Form (Q) und Verstärkung (G), und
der parametrische Equalizer ferner ein Mittel zum Einstellen eines von den anderen Benutzerparametern unabhängigen Symmetrieparameters umfasst, der kontinuierlich variiert werden kann, um einen glatten Übergang zwischen Low-Shelf-, glockenförmiger und High-Shelf-Filtercharakteristik des wenigstens einen Filterblocks (FIB) zu gewährleisten

**2.** Parametrischer Equalizer gemäß Anspruch 1, bei welchem
das Benutzerschnittstellenmittel (UIM) einen weiteren Symmetrieeinstellungsparameter (SYM) zum Einrichten einer variablen Symmetrie der Amplitudenantwort des wenigstens einen Filterblocks (FIB) umfasst,
das Benutzerschnittstellenmittel mittels Koeffizienteneinstellungsalgorithmen auf Filterkoeffizienteneinstellungen (FCS) des wenigstens einen Filterblocks (FIB) abgebildet wird, die nach Einrichtung die Einstellung des Benutzerschnittstellenmittels (UIM) widerspiegeln, und
der weitere Einstellungsparameter (SYM) eine Filterkoeffizienteneinstellung (FCS) bereitstellt, umfassend eine kombinierte Einstellung wenigstens einer Nullfrequenz, Polfrequenz, Null-Q und Pol-Q der Amplitudenantwort des wenigstens einen Filterblocks.

**3.** Parametrischer Equalizer gemäß Anspruch 1 oder 2, bei welchem
das Benutzersteuermittel ein Einstellung von Eckfrequenz (fc), Form (Q), Verstärkung und Symmetrie erleichtert.

**4.** Parametrischer Equalizer gemäß einem der Ansprüche 1-3, bei welchem die Filterkoeffizienteneinstellungen (FCS) digitale Koeffizienten umfassen.

5. Parametrischer Equalizer gemäß einem der Ansprüche 1-4, bei welchem die Filterkoeffizienteneinstellungen (FCS) analoge Werte umfassen, die mittels einstellbarer oder wählbarer Filterkomponenten des wenigstens einen Filtermittels eingerichtet werden.

6. Parametrischer Equalizer gemäß einem der Ansprüche 1-5, bei welchem das Filtermittel weniger als zwanzig, vorzugsweise weniger als zehn und am bevorzugtesten weniger als sechs einzeln einstellbare Filterblöcke (FIB) umfasst.

7. Parametrischer Equalizer gemäß einem der Ansprüche 1-6, bei welchem wenigstens einer der Filterblöcke einen biquadratischen Filter umfasst.

8. Parametrischer Equalizer gemäß einem der Ansprüche 1-7, bei welchem der parametrische Equalizer wenigstens einen, vorzugsweise wenigstens drei kaskadierte biquadratische Filterblöcke (FIB) umfasst.

9. Parametrischer Equalizer gemäß einem der Ansprüche 1-8, bei welchem das Filtermittel analog implementiert ist.

10. Parametrischer Equalizer gemäß einem der Ansprüche 1-9, bei welchem das Filtermittel digital implementiert ist.

11. Parametrischer Equalizer gemäß einem der Ansprüche 1-10, bei welchem das Filtermittel ein Verstärkungskompensationsmittel umfasst, das zur Kompensation der Änderung der Filterblockverstärkung geeignet ist, die von einer veränderten Einstellung des weiteren Einstellungsparameters hervorgerufen wird.

12. Parametrischer Equalizer gemäß einem der Ansprüche 1-11, bei welchem das Filtermittel ein Eckfrequenzkompensationsmittel umfasst, das zur Kompensation der Änderung der Eckfrequenz des Filterblocks geeignet ist, die von einer veränderten Einstellung des weiteren Einstellungsparameters hervorgerufen wird.

13. Parametrischer Equalizer gemäß einem der Ansprüche 1-12, bei welchem die Benutzerschnittstelle wenigstens vier verschiedene Asymmetrien einer Filtereinstellung wenigstens in einem Teil des Frequenzbereichs bereitstellt.

14. Parametrischer Equalizer gemäß einem der Ansprüche 1-13, bei welchem der weitere Einstellungsparameter (SYM) dem Benutzer ermöglicht, den Filterblock (FIB) zwischen einer Low-Shelf- und einer lügh-Shelf-Filtercharakteristik graduell zu transformieren.

15. Parametrischer Equalizer gemäß einem der Ansprüche 1-13, bei welchem der weitere Einstellungsparameter (SYM) dem Benutzer ermöglicht, den Filterblock (FIB) von einer Low-Shelf-Form in eine Glockenform und weiter in eine High-Shelf-Form zu transformieren, um dadurch wenigstens einen mehr als die drei Standardfiltertypen zu definieren.

16. Parametrischer Equalizer gemäß einem der Ansprüche 1-15, bei welchem die Anzahl von Einstellparametern der Anzahl nichttrivialer Freiheitsgrade des wenigstens einen Filterblocks (FIB) entspricht.

17. Parametrischer Equalizer gemäß einem der Ansprüche 1-16, bei welchem die Anzahl von Einstellparametern wenigstens die Anzahl nichttrivialer Freiheitsgrade des wenigstens einen biquadratischen Filterblocks (FIB) mal die Anzahl an Filterblöcken (FIB) des Filtermittels ist.

18. Parametrischer Equalizer gemäß einem der Ansprüche 1-17, bei welchem die Anzahl nichttrivialer Freiheitsgrade jedes einer Anzahl kaskadierter Filterblöcke wenigstens vier ist.

19. Parametrischer Equalizer gemäß einem der Ansprüche 1-18, bei welchem der Symmetrieparameter mittels der Benutzerschnittstelle auf wenigstens vier unterschiedliche Werte, vorzugsweise ein kontinuierliches Intervall von Werten in der digitalen oder analogen Ausführungsform, gesetzt werden kann.

20. Parametrischer Equalizer gemäß einem der Ansprüche 1-19, bei welchem die Einstellparameter in Filterkoeffizienteneinstellungen (FCS) konvertiert werden, die durch die Einstellung der Einstellungsparameter durch den Benutzer veranlasst werden.

21. Parametrischer Equalizer gemäß einem der Ansprüche 1-20, bei welchem die Konvertierung von Einstellungsparametern in Filterkoeffizienteneinstellungen invertierbar ist.

**22.** Parametrischer Equalizer gemäß einem der Ansprüche 1-21, bei welchem NDOFpar = NDOFcoef, wobei NDOFpar die Anzahl einstellbarer Equalizerparameter und NDOFcoef die Anzahl nichttrivialer Freiheitsgrade (fc,G,Q,Sym) ist.

**23.** Parametrischer Equalizer gemäß einem der Ansprüche 1-22, bei welchem gegebene Filterkoeffizienteneinstellungen in entsprechende Einstellungsparameter konvertiert werden können.

**24.** Parametrischer Equalizer gemäß einem der Ansprüche 1-23, bei welchem die Eckfrequenz eines Shelf-Filters eine Flankenmittenfrequenz bezeichnet, während die eines glockenförmigen Filters eine Mittenfrequenz bezeichnet.

**Revendications**

**1.** Egaliseur paramétrique comprenant :

un moyen de filtrage (FM), un moyen d'interface d'utilisateur (UIM), un moyen d'entrée d'un signal audio et un moyen de sortie d'un signal audio,
ledit moyen de filtrage comprenant au moins un bloc de filtre (FIB)
ledit moyen d'interface d'utilisateur (UIM) comprenant un moyen pour l'ajustement des premier, second et troisième paramètres d'utilisateur indépendants : d'une fréquence d'angle (fc), d'une forme (Q) et d'un gain (G), ledit égaliseur paramétrique comprenant en outre un moyen pour ajuster un paramètre de symétrie indépendant des autres paramètres d'utilisateur, qui peuvent continuellement varier afin de fournir une transition régulière entre une caractéristique de filtre de low-shelf, en forme de cloche et de high-shelf dudit au moins un bloc de filtre (FIB).

**2.** Egaliseur paramétrique selon la revendication 1, dans lequel
ledit moyen d'interface d'utilisateur (UIM) comprend un autre paramètre d'ajustement symétrique (SYM) pour établir une symétrie variable de la réponse en amplitude dudit au moins un bloc de filtre (FIB),
ledit moyen d'interface d'utilisateur est mappé au moyen d'algorithmes d'ajustement de coefficients dans des réglages de coefficients de filtre (FCS) d'au moins un bloc de filtre (FIB), qui lorsqu'il est établi reflète l'ajustement du moyen d'interface d'utilisateur (UIM)
ledit autre paramètre d'ajustement (SYM) fournit un réglage de coefficients de filtre (FCS) comprenant un ajustement combiné d'au moins une fréquence nulle, une fréquence de pole, Q nul et Q pole de la réponse en amplitude dudit au moins un bloc de filtre.

**3.** Egaliseur paramétrique selon la revendication 1 ou 2, dans lequel
ledit moyen de commande d'utilisateur facilite l'ajustement d'une fréquence d'angle (fc), de forme (Q), de gain et de symétrie.

**4.** Egaliseur paramétrique selon l'une quelconque des revendications 1 à 3, dans lequel
lesdits réglages de coefficient de filtre (FCS) comprennent des coefficients numériques.

**5.** Egaliseur paramétrique selon l'une quelconque des revendications 1 à 4, dans lequel
lesdits réglages de coefficients de filtre (FCS) comprennent des valeurs analogiques établies au moyen de composants de filtres ajustables ou sélectionnables dudit au moins un moyen de filtrage.

**6.** Egaliseur paramétrique selon l'une quelconque des revendications 1 à 5, dans lequel
ledit moyen de filtrage comprend moins que vingt blocs de filtre ajustables individuellement (FIB), préférablement moins que dix ou plus préférablement moins que six.

**7.** Egaliseur paramétrique selon l'une quelconque des revendications 1 à 6, dans lequel
au moins un desdits blocs de filtrage comprend un filtre bicarre.

**8.** Egaliseur paramétrique selon l'une quelconque des revendications 1 à 7, dans lequel
ledit égaliseur paramétrique comprend au moins un, préférablement au moins trois, blocs de filtres bicarres en cascade.

**9.** Egaliseur paramétrique selon l'une quelconque des revendications 1 à 8, dans lequel ledit moyen de filtrage est implémenté de façon analogique.

**10.** Egaliseur paramétrique selon l'une quelconque des revendications 1 à 9, dans lequel ledit moyen de filtrage est implémenté numériquement.

**11.** Egaliseur paramétrique selon l'une quelconque des revendications 1 à 10, dans lequel ledit moyen de filtrage comprend un moyen de compensation de gain adapté pour compenser l'altération du gain de bloc de filtrage résultant d'un changement de réglage de l'autre paramètre d'ajustement.

**12.** Egaliseur paramétrique selon l'une quelconque des revendications 1 à 11, dans lequel ledit moyen de filtrage comprend un moyen de compensation de fréquence d'angle adapté pour la compensation de l'altération de la fréquence d'angle du bloc de filtrage résultant d'un changement de réglage de l'autre paramètre d'ajustement.

**13.** Egaliseur paramétrique selon l'une quelconque des revendications 1 à 12, dans lequel ladite interface d'utilisateur fournit au moins quatre asymétries différentes de réglage de filtre au moins dans une partie de la gamme de fréquence.

**14.** Egaliseur paramétrique selon l'une quelconque des revendications 1 à 13, dans lequel ledit autre paramètre d'ajustement (SYM) permet à l'utilisateur de transformer graduellement le bloc de filtre (FIB) entre une caractéristique de filtre low-shelf et high-shelf.

**15.** Egaliseur paramétrique selon l'une quelconque des revendications 1 à 13, dans lequel ledit autre paramètre d'ajustement (SYM) permet à l'utilisateur de transformer progressivement le bloc de filtre (FIB) d'un low-shelf en une forme de cloche et une autre en un high-shelf, définissant ainsi au moins un de plus que lesdits trois types de filtre standards.

**16.** Egaliseur paramétrique selon l'une quelconque des revendications 1 à 15, dans lequel le nombre desdits paramètres d'ajustement correspond au nombre de degrés non triviaux de liberté d'au moins un bloc de filtre (FIB).

**17.** Egaliseur paramétrique selon l'une quelconque des revendications 1 à 16, dans lequel le nombre desdits paramètres d'ajustement est au moins le nombre de degrés non triviaux de liberté d'au moins un bloc de filtre bicarre (FIB) multiplié par le nombre de blocs de filtre (FIB) dudit moyen de filtrage.

**18.** Egaliseur paramétrique selon l'une quelconque des revendications 1 à 17, dans lequel le nombre de degrés non triviaux de liberté de chacun d'un nombre de blocs de filtre en cascade est au moins quatre.

**19.** Egaliseur paramétrique selon l'une quelconque des revendications 1 à 18, dans lequel le paramètre de symétrie peut être réglé au moyen de l'interface d'utilisateur à au moins quatre valeurs différentes, préférablement un intervalle de valeurs continues dans le mode de réalisation numérique ou analogique.

**20.** Egaliseur paramétrique selon l'une quelconque des revendications 1 à 19, dans lequel les paramètres d'ajustement sont convertis en réglages de coefficients de filtre (FCS) déclenchés par le réglage des paramètres d'ajustement par l'utilisateur.

**21.** Egaliseur paramétrique selon l'une quelconque des revendications 1 à 20, dans lequel la conversion des paramètres d'ajustement en réglages de coefficients de filtre est reversible.

**22.** Egaliseur paramétrique selon l'une quelconque des revendications 1 à 21, dans lequel NDOFpar $\geq$ NDOFcoef, où NDOFpar est le nombre de paramètres d'égaliseur ajustables et NDOFcoef est le nombre de degrés non triviaux de liberté (fc, G, Q, Sym).

**23.** Egaliseur paramétrique selon l'une quelconque des revendications 1 à 22, dans lequel des réglages de coefficients de filtre donnés peuvent être convertis en paramètres d'ajustement correspondants.

**24.** Egaliseur paramétrique selon l'une quelconque des revendications 1 à 23, dans lequel la fréquence d'angle d'un filtre shelf désigne une fréquence à mi-pente alors que celle d'un filtre en forme de cloche désigne une fréquence centrale.

*Fig.1*

G = [2 4 6 8 10]dB, fc = 1000 Hz, Q = 1, SYM = 0

Fig. 2a

G = 6 dB, fc = [250 500 1000 3000 4000] Hz, Q = 1, SYM = 0

Fig. 2b

G = 6 dB, fc = 1000 Hz, Q = [0,25  0,50  1,00  2,00  4,00], SYM = 0

*Fig. 2c*

G = 6 dB, fc = 1000 Hz, Q = 1, SYM = [-1,00  -0,67  -0,33  0,00  0,33  0,67  1,00]

*Fig. 2d*

G = 6 dB, fc = 1000 Hz, Q = 1, shape = [ -1.00 -0.67 -0.33  0.00  0.33  0.67  1.00]

*Fig. 3a*

G = 8dB, fc = 1000Hz, Q = 0.7, Sym = -1.00 -0.75 -0.50 -0.25  0.00  0.25  0.50  0.75  1.00

*Fig. 3b*

*Fig. 4*

Fig. 5

*Fig.6a*

*Fig.6b*

*Fig.7*